# EUROPEAN PATENT APPLICATION

(11) **EP 0 621 604 A1**
(43) Date of publication of application: **26.10.1994**
(21) Application number: 93830173.6
(22) Date of filing: 23.04.1993
(51) Int. Cl.: G11C 16/06

(54) **Method for recovering floating-gate memory cells with low threshold voltage in flash-EEPROM memory devices**

(71) Applicant: SGS-THOMSON MICROELECTRONICS S.r.l., I-20041 Agrate Brianza (Milano) (IT)
(72) Inventor: Bez, Roberto, I-20146 Milano (IT); Fratin, Lorenzo, I-20142 Milano (IT); Maurelli, Alfonso, I-20050 Sulbiate (Milano) (IT); Cantarelli, Daniele, I-20058 Villasanta (Milano) (IT); Ghezzi, Paolo, I-26027 Rivolta d'Adda (Cremona) (IT)
(74) Representative: Mittler, Enrico

(57) **Abstract**

A method for recovering flash-EEPROM memory cells (MC) with low threshold voltage is described. The method provide for the simultaneous application of a first voltage with a first prescribed value (V_{D}) and of a second voltage with a second prescribed value (V_{G}) to drain regions (D) of each of said memory cells (MC) and to gate regions (G) of the memory cell (MC) for a prescribed time interval suitable for submitting said memory cells (MC) to a prescribed threshold voltage shift. A reference ground voltage (GND) is concurrently applied to source regions (S) of said memory cells (MC).

## Description

The present invention relates to a method for recovering floating-gate memory cells with low threshold voltage in flash-EEPROM memory devices.

One of the most important problems affecting flash-EEPROM memory devices is the threshold voltage statistical distribution of the memory cells in consequence of an electrical erasing procedure.

It is in fact known that said distribution is not a pure Gaussian, showing an anomalous tail in the low threshold voltage range which may extend to negative values.

Since in flash-EEPROM memories the array of memory cells is generally arranged in the so-called NOR logic, in which groups of memory cells are shunted to a respective bit line, the existence of cells with low threshold voltage could lead to errors when reading other cells connected to the same bit line. If, for example, a bit line contains a depleted memory cell having a negative threshold voltage, and a programmed memory cell is addressed, this latter one will be erroneously read as a non-programmed cell, because the depleted cell will drain current even if it is not currently addressed.

Such problem is more evident in high density flash EEPROM memories, since the higher the number of cells, the higher the probability that some of them show low threshold voltage values. In such memories therefore, a tight distribution of threshold voltages after electrical erasure has to be guaranteed in order to achieve good device reliability and endurance.

It is therefore desirable to have the possibility, after any electrical erasure of the memory array or even of sectors of it, to recover those memory cells which show a too low threshold voltage or which are depleted.

For this purpose a method has been proposed providing a new erasing algorithm based on a two-steps procedure: the first step consists in an electrical erasure by means of Fowler-Nordheim tunneling between floating-gate and source, performed by applying a negative voltage to the control gate for a fixed amount of time of 100 ms; the second step consists in a threshold voltage adjustment by means of a source stress carried out by applying a voltage of 5 V to the source with grounded drain and control gate for a different fixed amount of time of 500 ms (Yamada et al. "A self-convergence erasing scheme for a simple stacked gate Flash EEPROM'' IEDM Tech. Dig. 11.4.1, p. 307, 1991).

Said adjustment is achieved thanks to the activation of a physical effect, called Channel Electron Induced Avalanche Hot Carrier (shortly CEIA-HC injection), which differs from Fowler-Nordheim tunneling and leads to a convergency of the threshold voltage of the cells to a "steady-state" value characterized by the condition that hot hole and hot electron injection into the floating gate are balanced. Moreover, this steady-state value is lower than the threshold voltage (UV V_{T}) of a virgin cell which has been exposed to Ultra-Violet (UV) radiation.

It has been recognized that the above mentioned method leads to a tighter statistical distribution of threshold voltages around said steady-state value, when compared with the distribution, obtained by means of pure Fowler-Nordheim erasing, around the UV V_{T}.

Since, however, the injection of hot carrier, in particular hot holes, into the floating gate can lead to tunnel oxide degradation, with the consequence of reducing the endurance characteristics of the memory device and limiting the number of program/erase cycles, it is necessary that during the erasing step the threshold voltages of the cells reach a value well below the UV V_{T}. In such a way the threshold voltage of the cells is below the steady-state value, and consequently mainly hot electron injection takes place during the second step.

The problem arises that, being the most part of the cells depleted after the first step has been performed, a large current must be sustained in the whole array while performing the second step.

Moreover, the management of a source stress is very easy only if a 5 Volt-only approach is used in the design of the memory device. On the contrary, if a high voltage device architecture is used, the management of bit lines voltages to consequently perform a drain stress on the memory cells, instead of the source voltage, is more suitable and suggests the possibility to act on single bit lines instead of the whole memory array.

In view of the state of the art just described, the object of the present invention is to provide a method for recovering low threshold voltage or depleted memory cells suitable for the application to high voltage flash-EEPROM memory devices.

According to the present invention such object is attained by a method for recovering floating-gate flash-EEPROM memory cells with low threshold voltage, characterized in that a first voltage with a first prescribed value and a second voltage with a second prescribed value are simultaneously applied to drain regions of the memory cell to be recovered and to gate regions of the memory cell for a prescribed time interval suitable for submitting said memory cell to a prescribed threshold voltage shift, while a reference ground voltage is concurrently applied to source regions of said memory cell.

A preferred embodiment of the present invention relates to the application of said method to recover low threshold voltage memory cells in a flash-EEPROM memory device, wherein the memory cells are arranged in a memory array, after an electrical erasing procedure.

In this embodiment said method can provide for a preliminary step, performed after said electrical erasing procedure, to detect the existence of memory cells with low threshold voltage, to inhibit the application of the recovery voltages if no such cells are found.

In such embodiment said method can be alternatively applied to the whole array of cells, to a sector of it or to a single bit line of memory cells.

Thanks to the present method, it is possible to submit low threshold voltage memory cells, arranged in a memory array, to a desired threshold voltage shift. The voltage values and the time interval are chosen according to the electrical characteristics of the memory cells so that the threshold voltage shift is sufficient to prevent errors in reading memory cells connected to a same bit line of the memory array.
Figure 1 illustrates a biasing scheme of a floating-gate flash-EEPROM memory cell suitable for applying the method of present invention;
Figure 2 illustrates the threshold voltage variation of said memory cell with time log when said method is applied using two particular values for said first and second voltages;
Figure 3 illustrates three different threshold voltage variation curves obtained at three different values of said first voltage;
Figure 4 illustrates three different threshold variation curves obtained at three different values of said second voltage.

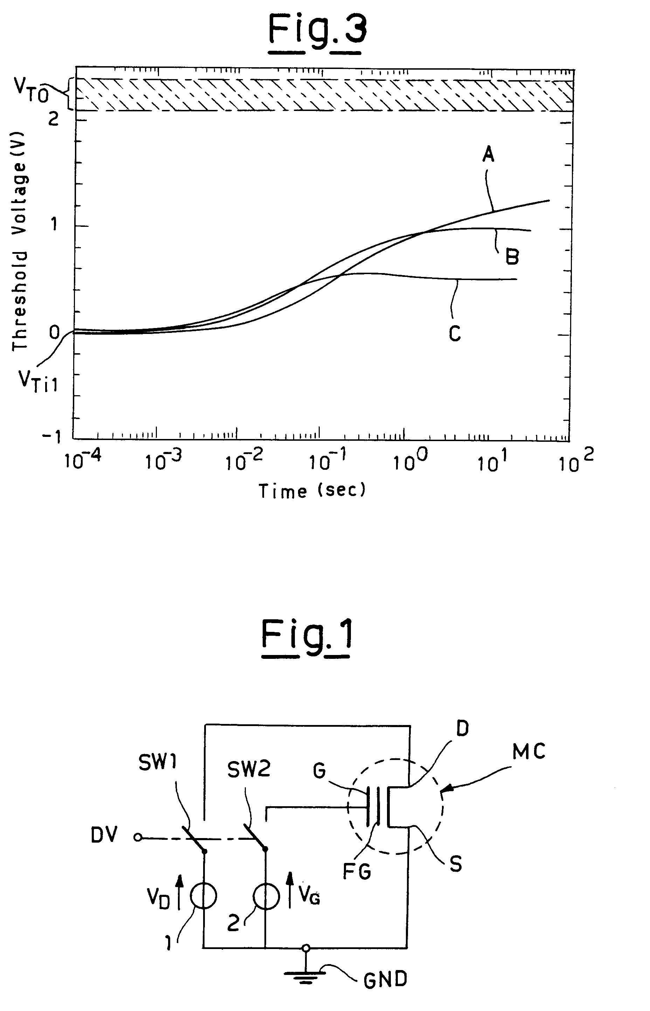

With reference to Figure 1, a biasing scheme is shown which is suitable for recovering a floating-gate FG flash-EEPROM memory cell MC with low threshold voltage.

Said biasing scheme provides for a first voltage generator 1 for generating a first voltage with a first prescribed value V_{D} and a second voltage generator 2 for generating a second voltage with a second prescribed value V_{G}. The voltage generator 1 is referred to a reference ground voltage GND and is connected through a switch SW1 to a drain region D of the cell MC. The voltage generator 2 is also referred to the reference ground voltage GND and is connected through a switch SW2 to a gate region G of the cell MC. A source region S of the cell MC is connected to the reference ground voltage GND. The switches SW1 and SW2 are both driven by a driving signal DV which controls their closing and opening movements.

The memory cell MC can belong to an array of other similar memory cells MC (not shown), representing for example a memory matrix of a flash-EEPROM memory device; in this case, if the array is arranged in the so-called NOR logic, groups of cells MC are connected by their drain regions D to respective bit lines, and the described biasing scheme can be applied to one of these bit lines, as well as to a group of bit lines representing a sector of the mamory matrix, as well as to the whole memory matrix.

In the following, experimental behaviour of a memory cell with a channel width of 0.8 microns and a channel length of 0.9 microns is described.

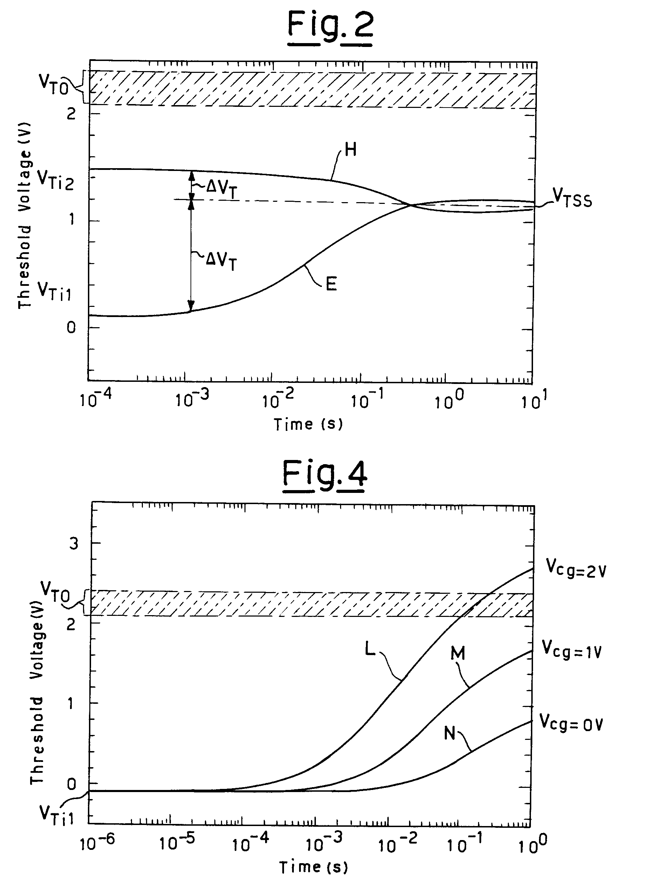

In Figure 2, representing the threshold voltage variation of the memory cell MC with time log, it is supposed that the memory cell MC can have two different initial threshold voltages, respectively V_{Ti1} of approximately 0 V and V_{Ti2} of 1.5 V, for example in consequence of an electrical erasure by means of Fowler-Nordheim tunneling of electrons from the floating gate FG to the source S. In this figure a range of values corresponding to the distribution of the threshold voltage V_{T0} of a virgin cell (i.e. one submitted to Ultra-Violet light erasure) is also shown.

When the two voltages V_{D} and V_{G}, chosen to be respectively 5.5 V and 0 V, are applied to the drain D and to the control gate G, the cell MC undergoes a threshold voltage shift ΔV_{T} which is positive for the initial threshold voltage V_{Ti1} (curve E) and negative for the initial threshold voltage V_{Ti2} (curve H). After a time of about 500 ms, however, both of the curves E and H converge to a steady-state threshold value V_{TSS}. This is due the activation of the cited CEIA-HC effect which in the case of curve E leads to hot electrons injection into the floating gate FG of the cell MC, while in the case of curve H hot holes are injected into the floating gate FG instead of hot electrons. Once the steady-state value V_{TSS} is reached, a complete equilibrium between the hot electron and hot hole injection into the floating gate FG is obtained, and the memory cell MC does not undergo any further threshold voltage variation.

This steady-state threshold voltage value V_{TSS} depends on both the V_{D} voltage value (as shown in figure 3, where the three curves A, B and C have been obtained with a V_{G} voltage value of 0 V and with V_{D} of 5 V, 5.5 V and 6 V respectively) and on the V_{G} voltage value (as shown in figure 4, where the three curves L, M and N have been obtained with a V_{D} voltage value of 5V and with V_{G} of 2 V, 1 V and 0 V respectively).

In choosing the voltage value for V_{D}, two opposite requirements should be considered: the first one is gate oxide degradation due to hot holes injection; since it is known that hot holes injection rate increase with increasing V_{D}, this last parameter should be kept as lower as possible. The second requirement is the time needed to reach the steady-state, which decrease with increasing V_{D}. Accordingly, a trade-off between these two requirement should be found. The experimental results on the present particular memory cell MC have shown that said trade-off is reached for V_{D} values ranging from 4 V and 5 V, requiring a time ranging from 100 ms to 1s to achieve partial recovery of the depleted memory cell MC.

Given this voltage range for V_{D}, the choice of the V_{G} value is to be made in view of the impact of this parameter on oxide damaging due to hot holes injection, on the time needed to reach the steady-state condition and on the drain current of the cell that must be sustained. This last effect is expecially important when applying the recovery method to an array of memory cells MC, or even to a single bit line of memory cells MC of said array. Again, experimental results have proved that biasing conditions of V_{G} equal to 0 V and V_{D} ranging from 4 V to 5 V can prevent from oxide damaging and from excessive drain currents. In the case of V_{G} = 2 V, even if hot electrons injection is predominant, drain current problems arises: it has been observed that the current drained by a single bit line of memory cells MC is in the range of mA, leading to an excessive current when the whole array of memory cell MC or even a sector of it are to be recovered. For V_{G} = 1 V, instead, even if the drain current is in the range of microamperes, oxide damaging problems arises, due to a significant injection of hot holes.

## Claims

1. A method for recovering floating-gate (FG) flash-EEPROM memory cells (MC) with low threshold voltage (V_{Ti1}, V_{Ti2}), characterized in that a first voltage with a first prescribed value (V_{D}) and a second voltage with a second prescribed value (V_{G}) are simultaneously applied to drain regions (D) of the memory cell (MC) to be recovered and to gate regions (G) of the memory cell (MC) for a prescribed time interval suitable for submitting said memory cell (MC) to a prescribed threshold voltage shift, while a reference ground voltage (GND) is concurrently applied to source regions (S) of said memory cell (MC).

2. The method according to claim 1, characterized in that said method is performed on memory cells (MC) belonging to a memory array of a flash-EEPROM memory device which has been submitted to an electrical erasing procedure.

3. The method according to claim 2, characterized in that a preliminary step, performed after said electrical erasing procedure, is provided for detecting the existence of low threshold voltage memory cells (MC) and to consequently inhibit the application of said first voltage and second voltage if no such memory cell (MC) exists.

4. The method according to claim 2 or 3, characterized in that said first voltage and second voltage are alternatively applied to different sectors of said memory array.

5. The method according to claim 2 or 3, characterized in that said first voltage and second voltage are alternatively applied to different bit lines of said memory array.

6. The method according to claim 2 or 3, characterized in that said first voltage and second voltage are simultaneously applied to all the memory cells (MC) of said memory array.

7. The method according to any of claims 1 to 6, characterized in that said first prescribed value (V_{D}) is chosen inside a first range of voltage values which are higher than said second prescribed value (V_{G}).

8. The method according to any of claims 1 to 6, characterized in that said second prescribed value (V_{G}) is chosen inside a second range of voltage values which are lower than said first prescribed value (V_{D}).
